# EUROPÄISCHE PATENTANMELDUNG

(11) **EP 4 814 773 A1**
(43) Veröffentlichungstag der Anmeldung: **30.09.2026**
(21) Anmeldenummer: 25167131.9
(22) Anmeldetag: 28.03.2025
(51) Int. Cl.: G06F 30/12, G06F 30/13, G06F 30/27, G06F 40/20, G06F 40/30, G06F 40/40, G06N 3/04

(54) **VORRICHTUNG UND COMPUTERIMPLEMENTIERTES VERFAHREN ZUM BEARBEITEN EINES COMPUTERLESBAREN 3D-MODELLS EINES TECHNISCHEN SYSTEMS**

(71) Anmelder: Siemens Aktiengesellschaft, 80333 München (DE)
(72) Erfinder: Fischer, Jan, 81541 München (DE); Held, Harald, 85461 Bockhorn (DE); Maier, Leonie, 80801 München (DE); Wolfrum, Philipp, 81539 München (DE)
(74) Vertreter: Siemens Patent Attorneys

(57) **Zusammenfassung**

Die Erfindung betrifft eine Vorrichtung zum Bearbeiten eines computerlesbaren 3D-Modells eines technischen Systems, wobei die Vorrichtung umfasst:
• eine Transformationseinheit, die derart eingerichtet ist, das computerlesbare 3D-Modell des technischen Systems in Modelldaten, die für eine Verarbeitung durch ein Large-Language-Modell geeignet sind, zu transformieren und die Modelldaten bereitzustellen,
• eine erste Eingabeeinheit, die derart eingerichtet ist, eine Kontextinformation für das Large-Language-Modell bereitzustellen, wobei die Kontextinformation die Modelldaten und eine API-Spezifikation einer API eines Bearbeitungstools zum Bearbeiten des 3D-Modells umfasst,
• eine zweite Eingabeeinheit, die derart eingerichtet ist, Eingabedaten in natürlicher Sprache einzulesen, wobei die Eingabedaten eine Angabe zur Bearbeitung des 3D-Modells umfassen,
• einen Prozessor, der derart eingerichtet ist, das Large-Language-Modell unter Berücksichtigung der Eingabedaten und der Kontextinformation auszuführen, wobei durch das Large-Language-Modell auf Basis der Kontextinformation ein Funktionsaufruf für das Bearbeitungstool zur Bearbeitung des 3D-Modells gemäß der Eingabedaten generiert und der generierte Funktionsaufruf ausgegeben wird,
und
• die API des Bearbeitungstools zum Bearbeiten des 3D-Modells, die derart eingerichtet ist, das Bearbeitungstool anzusteuern und eine Bearbeitung des 3D-Modells gemäß dem Funktionsaufruf zu veranlassen.

## Beschreibung

Die Erfindung betrifft eine Vorrichtung und ein computerimplementiertes Verfahren zum Bearbeiten eines computerlesbaren 3D-Modells eines technischen Systems, sowie ein Computerprogrammprodukt.

Die Darstellung und Nutzung von dreidimensionalen (3D) Szenen oder 3D-Umgebungen wird im industriellen Kontext immer wichtiger. Beispielsweise kann für ein technisches System, wie z.B. eine industrielle Anlage, ein computerlesbares 3D-Modell, wie z.B. ein 3D-CAD-Modell, vorliegen und verarbeitet werden. Eine Anwendung dafür ist beispielsweise das Industrial Metaverse. Allerdings ist für eine Bearbeitung und/oder Interaktion mit einer solchen 3D-Szene in der Regel Expertenwissen nötig, um eine Bearbeitung in einem geeigneten Bearbeitungstool durchzuführen.

Es ist daher eine Aufgabe der Erfindung, eine Bearbeitung eines computerlesbaren 3D-Modells eines technischen Systems zu vereinfachen.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt.

Gemäß einem ersten Aspekt betrifft die Erfindung eine Vorrichtung zum Bearbeiten eines computerlesbaren 3D-Modells eines technischen Systems, wobei die Vorrichtung umfasst:
- eine Transformationseinheit, die derart eingerichtet ist, das computerlesbare 3D-Modell des technischen Systems in Modelldaten, die für eine Verarbeitung durch ein Large-Language-Modell geeignet sind, zu transformieren und die Modelldaten bereitzustellen,
- eine erste Eingabeeinheit, die derart eingerichtet ist, eine Kontextinformation für das Large-Language-Modell bereitzustellen, wobei die Kontextinformation die Modelldaten und eine API-Spezifikation einer API eines Bearbeitungstools zum Bearbeiten des 3D-Modells umfasst,
- eine zweite Eingabeeinheit, die derart eingerichtet ist, Eingabedaten in natürlicher Sprache einzulesen, wobei die Eingabedaten eine Angabe zur Bearbeitung des 3D-Modells umfassen,
- einen Prozessor, der derart eingerichtet ist, das Large-Language-Modell unter Berücksichtigung der Eingabedaten und der Kontextinformation auszuführen, wobei durch das Large-Language-Modell auf Basis der Kontextinformation ein Funktionsaufruf für das Bearbeitungstool zur Bearbeitung des 3D-Modells gemäß der Eingabedaten generiert und der generierte Funktionsaufruf ausgegeben wird,
   und
- die API des Bearbeitungstools zum Bearbeiten des 3D-Modells, die derart eingerichtet ist, das Bearbeitungstool anzusteuern und eine Bearbeitung des 3D-Modells gemäß dem Funktionsaufruf zu veranlassen.

Es ist ein Vorteil der vorliegenden Erfindung, dass ein Nutzer ein computerlesbares 3D-Modell mit Eingabebefehlen in natürlicher Sprache bearbeiten kann. Beispielsweise kann ein Nutzer in einer interaktiven 3D-Umgebung, wie z.B. BIM, Unity oder Plant Simulation, natürliche Sprache verwenden, um mit der 3D-Szene zu interagieren, wie z.B. das 3D-Modell durch bekannte, natürlichsprachliche Ausdrücke zu verändern. Dies wird durch die Anbindung an ein Large-Language-Modell (LLM) ermöglicht, wobei das 3D-Modell in Form von geeigneten Modelldaten dem LLM als Kontextinformation zur Verfügung gestellt wird. Das mit diesem Kontext ausgestattete LLM ermöglicht dann eine natürlichsprachliche Interaktion mit der 3D-Szene. Das Ergebnis der natürlichsprachlichen Interaktion wird aus dem LLM an ein Bearbeitungstool übergegeben. Insbesondere ist es möglich, ein vortrainiertes bzw. bestehendes LLM zu nutzen.

Dieser Ansatz beschleunigt die Bearbeitung und ist für einen Nutzer intuitiver. Beispielsweise kann eine Anweisung "Die Maschine hinter der anderen." oder geometrische oder farbliche Anweisungen verwendet werden, um ein Objekt im 3D-Modell zu identifizieren und/oder eine Bearbeitung des 3D-Modells anzusteuern. Außerdem können derart auch Parameter oder Positionen von Objekten in der 3D-Szene angepasst werden.

In einer vorteilhaften Ausführungsform der Vorrichtung kann die Transformation des 3D-Modells in die Modelldaten eine Übersetzung des 3D-Modells in natürlicher Sprache umfassen.

Das vorliegende computerlesbare 3D-Modell wird beispielsweise in natürliche Sprache übersetzt, wie z.B. eine natürlichsprachliche Beschreibung der 3D-Szene.

In einer weiteren Ausführungsform der Vorrichtung kann die Transformation des 3D-Modells in die Modelldaten abhängig von einer Angabe eines Dateiformats des 3D-Modells erfolgen.

In einer weiteren Ausführungsform der Vorrichtung können die Modelldaten folgende Informationen umfassen:
- einen Objektidentifikator eines Objekts des technischen Systems,
- eine textbasierte Beschreibung eines Objektmerkmals eines Objekts des technischen Systems,
- 2D-Bilder aus verschiedenen Blickwinkeln eines Objekts des 3D-Modells oder des 3D-Modells,
- ein 2D-Bild eines Objekts des 3D-Modells oder des 3D-Modells in Abhängigkeit einer vorgegebenen Blickrichtung eines Nutzers,
- dynamische Parameter des 3D-Modells,
   und/oder
- eine relative Position eines Objekts zu einem anderen Objekt des 3D-Modells.

In einer weiteren Ausführungsform kann die Vorrichtung eine Ausgabeeinheit umfassen, die derart eingerichtet ist, eine Statusinformation über die Bearbeitung des 3D-Modells als Ausgabedaten des Large-Language-Modells in natürlicher Sprache auszugeben.

In einer weiteren Ausführungsform der Vorrichtung kann das 3D-Modell ein CAD-Modell, ein BIM-Modell oder ein Game-Engine-Modell sein.

Gemäß einem zweiten Aspekt betrifft die Erfindung ein computerimplementiertes Verfahren zum Bearbeiten eines computerlesbaren 3D-Modells eines technischen Systems, mit den Verfahrensschritten:
- Transformieren des computerlesbaren 3D-Modells des technischen Systems in Modelldaten, die für eine Verarbeitung durch ein Large-Language-Modell geeignet sind, und Bereitstellen der Modelldaten,
- Bereitstellen einer Kontextinformation für das Large-Language-Modell, wobei die Kontextinformation die transformierten Modelldaten und eine API-Spezifikation einer API eines Bearbeitungstools zum Bearbeiten des 3D-Modells umfasst,
- Einlesen von Eingabedaten in natürlicher Sprache, wobei die Eingabedaten eine Angabe zur Bearbeitung des 3D-Modells umfassen,
- Ausführen des Large-Language-Modells unter Berücksichtigung der Eingabedaten und der Kontextinformation,
- Generieren eines Funktionsaufrufs für das Bearbeitungstool zur Bearbeitung des 3D-Modells gemäß der Eingabedaten mittels des Large-Language-Modells auf Basis der Kontextinformation,
- Ausgeben des generierten Funktionsaufrufs,
   und
   - Ansteuern des Bearbeitungstools (über die API des Bearbeitungstools) zum Bearbeiten des 3D-Modells gemäß dem Funktionsaufruf.

Des Weiteren betrifft die Erfindung ein Computerprogrammprodukt, das direkt in einen programmierbaren Computer ladbar ist, umfassend Programmcodeteile, die bei der Ausführung des Programms durch einen Computer diesen veranlassen, die Schritte eines erfindungsgemäßen Verfahrens auszuführen.

Ein Computerprogrammprodukt kann beispielsweise auf einem Speichermedium, wie z.B. Speicherkarte, USB-Stick, CD-ROM, DVD, ein nichtflüchtiger/dauerhaftes Speichermedium (engl. Non-transitory storage Medium) oder auch in Form einer herunterladbaren Datei von einem Server in einem Netzwerk bereitgestellt oder geliefert werden.

Ausführungsbeispiele der Erfindung sind in den Zeichnungen beispielhaft dargestellt und werden anhand der nachfolgenden Beschreibung näher erläutert. Es zeigen:
- Fig. 1:: ein Ausführungsbeispiel einer erfindungsgemäßen Vorrichtung; und
- Fig. 2:: ein Ausführungsbeispiel eines erfindungsgemäßen computerimplementierten Verfahrens.

Einander entsprechende Teile sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

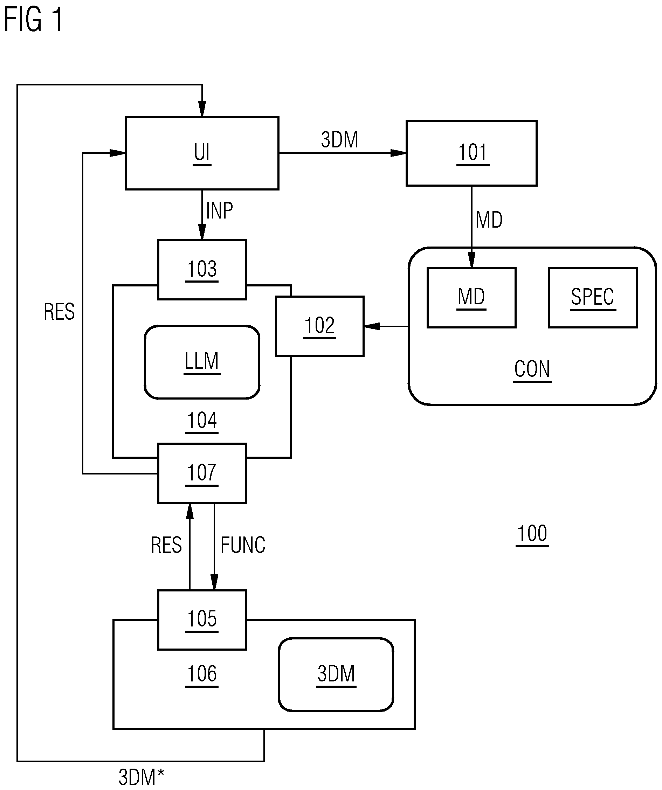

Figur 1 zeigt ein Ausführungsbeispiel einer Vorrichtung 100 zum Bearbeiten eines computerlesbaren 3D-Modells 3DM eines technischen Systems. Das technische System kann beispielsweise ein Industrieroboter oder eine industrielle Anlage sein und wird als 3D-Modell repräsentiert. Das 3D-Modell kann beispielsweise ein 3D CAD-Modell, ein BIM-Modell oder ein Game-Engine-Modell sein.

Die Vorrichtung 100 umfasst eine Transformationseinheit 101, eine erste Eingabeeinheit 102, eine zweite Eingabeeinheit 103, einen Prozessor 104, und eine Schnittstelle bzw. API 105 zu einem Bearbeitungstool 106, das zum Bearbeiten des computerlesbaren 3D-Modells 3DM geeignet ist, d.h. das Bearbeitungstool 106 ist abhängig vom Dateiformat des 3D-Modells (wie z.B. CAD-Modell). Außerdem kann die Vorrichtung 100 auch das Bearbeitungstool 106 umfassen. Es ist aber auch möglich, dass die Vorrichtung 100 lediglich über die API 105 auf das Bearbeitungstool zugreift.

Weiter kann die Vorrichtung eine Benutzerschnittstelle Ul zum Bedienen oder Steuern der Vorrichtung 100 durch einen Nutzer umfassen. Der Prozessor 104 ist insbesondere derart eingerichtet, dass er auf ein, vorzugsweise vortrainiertes, Large-Language-Modell zugreifen kann. Alternativ kann die Vorrichtung 100 auch das trainierte Large-Language-Modell selbst umfassen.

Die Transformationseinheit 101 ist derart eingerichtet, das computerlesbare 3D-Modell 3DM des technischen Systems in Modelldaten MD, die für eine Verarbeitung durch ein Large-Language-Modell LLM geeignet sind, zu transformieren und die Modelldaten MD bereitzustellen. Die Modelldaten MD umfassen beispielsweise Informationen aus dem 3D-Modell in natürlicher Sprache, wie z.B. eine natürlichsprachliche Beschreibung der 3D-Szene, die beispielsweise mit Hilfe eines Übersetzungstools aus Koordinaten aus dem 3D-Modell generiert werden kann.

Die Modelldaten MD werden vorzugsweise generiert, indem das 3D-Modell 3DM in natürliche Sprache übersetzt wird. Zusätzlich oder alternativ können die Modelldaten MD in Abhängigkeit eines angegebenen Dateiformats des 3D-Modells transformiert werden.

Die Modelldaten MD ermöglichen eine natürlichsprachliche Beschreibung der 3D-Szene und umfassen vorzugsweise:
- mindestens einen Objektidentifikator (Objekt-ID) eines Objekts des technischen Systems,
- eine textbasierte Beschreibung eines Objektmerkmals eines Objekts des technischen Systems, wie z.B. Farbe, statische physikalische Parameter,
- 2D-Bilder aus verschiedenen Blickwinkeln eines Objekts des 3D-Modells oder des 3D-Modells,
- ein 2D-Bild eines Objekts des 3D-Modells oder des 3D-Modells in Abhängigkeit einer vorgegebenen Blickrichtung eines Nutzers,
- dynamische Parameter des 3D-Modells, wie z.B. Lichteinfall, dynamische physikalische Informationen über ein Objekt,
   und/oder
- eine relative Position eines Objekts zu einem anderen Objekt des 3D-Modells.

Die Information aus dem 3D-Modell liegt somit in einem Format vor, dass ein Large-Language-Modell LLM verarbeiten kann.

Die Modelldaten MD umfassen insbesondere statische Daten aus dem 3D-Modell, sowie dynamische Daten, die die aktuelle Szene bzw. deren Orientierung in Bezug auf den Nutzer bzw. die aktuelle Nutzerposition beschreiben. Dazu umfassen die Modelldaten MD die Beschreibung der vorhandenen Objekte, wobei diese Beschreibung in natürliche Sprache übersetzt wird. Zusätzlich wird für die Bearbeitung eine Information über die Orientierung der Objekte im 3D-Modell bzw. der 3D-Szene in Bezug auf die aktuelle Position des Nutzers benötigt. Diese Information ergibt sich beispielsweise aus dem 2D-Bild eines Objekts der 3D-Szene oder der 3D-Szene selbst. Beispielsweise kann ein solches 2D-Bild als Screenshot generiert werden.

Zusätzlich können die Modelldaten mit natürlichsprachlichen Informationen zum 3D-Modell angereichert werden, die das LLM unterstützen, das 3D-Modell zu interpretieren.

Außerdem können Informationen einer im Hintergrund laufenden computergestützten Simulation auf Basis des 3D-Modells 3DM integriert werden. So können beispielsweise Daten der Simulation, wie z.B. Druck, Geschwindigkeit etc., als Modelldaten bereitgestellt und so zur Identifikation von Objekten der 3D-Szene genutzt werden.

Die erste Eingabeeinheit 102 ist derart eingerichtet, eine Kontextinformation CON für das Large-Language-Modell LLM bereitzustellen. Die Kontextinformation CON umfasst dabei die Modelldaten MD und eine API-Spezifikation SPEC der API der Bearbeitungstools zum Bearbeiten des 3D-Modells 3DM. Insbesondere kann ein Bearbeitungstool in Abhängigkeit des jeweiligen Dateifomats des 3D-Modells gewählt werden.

Die zweite Eingabeeinheit 103 ist derart eingerichtet, Eingabedaten INP in natürlicher Sprache einzulesen. Die Eingabedaten INP, auch als Prompt bezeichnet, umfassen eine Angabe zur Bearbeitung des 3D-Modells umfassen. Beispielsweise kann ein Nutzer über den Prompt einen natürlichsprachlichen Bearbeitungsbefehl, wie z.B. "Ändere Parameter X von Objekt Y auf Wert Z".

Der Prozessor 104 ist derart eingerichtet, das Large-Language-Modell LLM anzusteuern und unter Berücksichtigung der Eingabedaten INP und der Kontextinformation CON auszuführen. Dabei wird durch das Large-Language-Modell LLM auf Basis der Kontextinformation CON ein Funktionsaufruf FUNC für das Bearbeitungstool 106 zur Bearbeitung des 3D-Modells gemäß der Eingabedaten INP generiert und der generierte Funktionsaufruf FUNC wird ausgegeben.

Das mit diesem Kontext ausgestattete Large-Language-Modell LLM ermöglicht dann die natürlichsprachliche Interaktion mit dem 3D-Modell 3DM. Dadurch dass das Large-Language-Modell LLM über die Kontextinformation CON die Spezifikation SPEC der API kennt, kann ein Funktionsaufruf FUNC generiert werden, der das jeweilige Bearbeitungstool 106 direkt ansteuern und darin das 3D-Modell 3DM bearbeiten kann. Der Funktionsaufruf FUNC umfasst dann Bearbeitungsbefehle gemäß der Nutzereingabe INP.

Die API 105 des Bearbeitungstools 106 zum Bearbeiten des computerlesbaren 3D-Modells ist derart eingerichtet, das Bearbeitungstool 106 anzusteuern und eine Bearbeitung des 3D-Modells gemäß dem Funktionsaufruf FUNC zu veranlassen. Die Bearbeitung, wie z.B. Anpassung oder Änderung, des 3D-Modells 3DM kann dann gemäß dem Funktionsaufruf FUNC im Bearbeitungstool 106 erfolgen. Das bearbeitete 3D-Modell 3DM* kann anschließend vom Bearbeitungstool 106 an die Benutzerschnittstelle UI ausgegeben werden.

Die Vorrichtung 100 kann weiter eine Ausgabeeinheit 107 umfassen, die derart eingerichtet ist, eine Statusinformation RES über die Bearbeitung des 3D-Modells als Ausgabedaten des Large-Language-Modells in natürlicher Sprache auszugeben. Beispielsweise kann die Statusinformation RES ein Bearbeitungsergebnis umfassen. Das Bearbeitungstool 106 kann beispielsweise die Statusinformation RES bereitstellen. Die Statusinformation RES kann beispielsweise über die Benutzerschnittstelle UI ausgegeben werden.

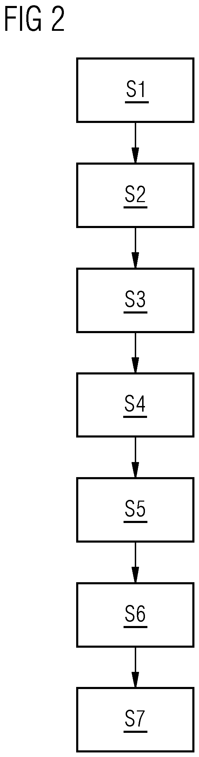

Figur 2 zeigt ein Ausführungsbeispiel des computerimplementierten Verfahrens zum Bearbeiten eines computerlesbaren 3D-Modells eines technischen Systems.

Das Verfahren umfasst die folgende Verfahrensschritte:
In einem ersten Schritt S1 wird das computerlesbare 3D-Modell des technischen Systems in Modelldaten transformiert, die für eine Verarbeitung durch ein Large-Language-Modell geeignet sind, und die Modelldaten werden bereitgestellt. Vorzugsweise stellen die Modelldaten eine natürlichsprachliche Beschreibung des 3D-Modells dar.

Im nächsten Schritt S2 wird eine Kontextinformation für das Large-Language-Modell bereitgestellt, wobei die Kontextinformation die transformierten Modelldaten und eine API-Spezifikation einer API eines Bearbeitungstools zum Bearbeiten des 3D-Modells umfasst. Die Kontextinformation gibt somit vorzugsweise an, mit welchem Bearbeitungstool das 3D-Modell bearbeitet werden kann. Außerdem umfasst die Kontextinformation Details zur 3D-Szene in natürlicher Sprache, so dass das LLM diese Information verarbeiten kann.

Im nächsten Schritt S3 werden Eingabedaten (Prompt/User Prompt) in natürlicher Sprache eingelesen, wobei die Eingabedaten eine Angabe zur Bearbeitung des 3D-Modells umfassen. Beispielsweise kann ein Nutzer eine natürlichsprachliche Anweisung an das LLM übergeben, wie z.B. "Ändere den Winkel des Roboterarms auf der rechten Seite zu 50 Grad".

Im nächsten Schritt S4 wird das Large-Language-Modell unter Berücksichtigung der Eingabedaten und der Kontextinformation ausgeführt. Dazu werden die Eingabedaten und die Kontextinformation dem Large-Language-Modell zur Verfügung gestellt.

Im nächsten Schritt S5 wird durch das Large-Language-Modell und auf Basis der Kontextinformation ein Funktionsaufruf für das Bearbeitungstool zum Bearbeiten des 3D-Modells gemäß der Eingabedaten generiert.

Im nächsten Schritt S6 wird der generierte Funktionsaufrufs ausgegeben.

Im nächsten Schritt S7 wird das Bearbeitungstool über die API des Bearbeitungstools zum Bearbeiten des 3D-Modells gemäß dem Funktionsaufruf angesteuert. Eine Bearbeitung des 3D-Modells erfolgt dann im Bearbeitungstool gemäß dem generierten Funktionsaufruf. Anschließend kann eine Statusinformation und/oder das bearbeitete 3D-Modell über eine Benutzerschnittstelle bereitgestellt werden.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Vorrichtung (100) zum Bearbeiten eines computerlesbaren 3D-Modells (3DM) eines technischen Systems, wobei die Vorrichtung umfasst:
• eine Transformationseinheit (101), die derart eingerichtet ist, das computerlesbare 3D-Modell (3DM) des technischen Systems in Modelldaten (MD), die für eine Verarbeitung durch ein Large-Language-Modell (LLM) geeignet sind, zu transformieren und die Modelldaten (MD) bereitzustellen,
• eine erste Eingabeeinheit (102), die derart eingerichtet ist, eine Kontextinformation (CON) für das Large-Language-Modell (LLM) bereitzustellen, wobei die Kontextinformation (CON) die Modelldaten (MD) und eine API-Spezifikation (SPEC) einer API eines Bearbeitungstools zum Bearbeiten des 3D-Modells (3DM) umfasst,
• eine zweite Eingabeeinheit (103), die derart eingerichtet ist, Eingabedaten (INP) in natürlicher Sprache einzulesen, wobei die Eingabedaten (INP) eine Angabe zur Bearbeitung des 3D-Modells umfassen,
• einen Prozessor (104), der derart eingerichtet ist, das Large-Language-Modell (LLM) unter Berücksichtigung der Eingabedaten (INP) und der Kontextinformation (CON) auszuführen, wobei durch das Large-Language-Modell (LLM) auf Basis der Kontextinformation (CON) ein Funktionsaufruf (FUNC) für das Bearbeitungstool zur Bearbeitung des 3D-Modells gemäß der Eingabedaten (INP) generiert und der generierte Funktionsaufruf (FUNC) ausgegeben wird,
und
• die API (105) des Bearbeitungstools (106) zum Bearbeiten des 3D-Modells, die derart eingerichtet ist, das Bearbeitungstool (106) anzusteuern und eine Bearbeitung des 3D-Modells gemäß dem Funktionsaufruf zu veranlassen.

2. Vorrichtung nach Anspruch 1, wobei die Transformation des 3D-Modells in die Modelldaten eine Übersetzung des 3D-Modells in natürlicher Sprache umfasst.

3. Vorrichtung nach Anspruch 1 oder 2, wobei die Transformation des 3D-Modells (3DM) in die Modelldaten (MD) abhängig von einer Angabe eines Dateiformats des 3D-Modells erfolgt.

4. Vorrichtung nach einem der vorhergehenden Ansprüche, wobei die Modelldaten (MD) folgende Informationen umfassen:
• einen Objektidentifikator eines Objekts des technischen Systems,
• eine textbasierte Beschreibung eines Objektmerkmals eines Objekts des technischen Systems,
• 2D-Bilder aus verschiedenen Blickwinkeln eines Objekts des 3D-Modells oder des 3D-Modells,
• ein 2D-Bild eines Objekts des 3D-Modells oder des 3D-Modells in Abhängigkeit einer vorgegebenen Blickrichtung eines Nutzers,
• dynamische Parameter des 3D-Modells,
und/oder
• eine relative Position eines Objekts zu einem anderen Objekt des 3D-Modells.

5. Vorrichtung nach einem der vorhergehenden Ansprüche weiter umfassend eine Ausgabeeinheit (107), die derart eingerichtet ist, eine Statusinformation (RES) über die Bearbeitung des 3D-Modells als Ausgabedaten des Large-Language-Modells in natürlicher Sprache auszugeben.

6. Vorrichtung nach einem der vorhergehenden Ansprüche, wobei das 3D-Modell ein CAD-Modell, ein BIM-Modell oder ein Game-Engine-Modell ist.

7. Computerimplementiertes Verfahren zum Bearbeiten eines computerlesbaren 3D-Modells eines technischen Systems, mit den Verfahrensschritten:
• Transformieren (S1) des computerlesbaren 3D-Modells des technischen Systems in Modelldaten, die für eine Verarbeitung durch ein Large-Language-Modell geeignet sind, und Bereitstellen der Modelldaten,
• Bereitstellen (S2) einer Kontextinformation für das Large-Language-Modell, wobei die Kontextinformation die transformierten Modelldaten und eine API-Spezifikation einer API eines Bearbeitungstools zum Bearbeiten des 3D-Modells umfasst,
• Einlesen (S3) von Eingabedaten in natürlicher Sprache, wobei die Eingabedaten eine Angabe zur Bearbeitung des 3D-Modells umfassen,
• Ausführen (S4) des Large-Language-Modells unter Berücksichtigung der Eingabedaten und der Kontextinformation,
• Generieren (S5) eines Funktionsaufrufs für das Bearbeitungstool zur Bearbeitung des 3D-Modells gemäß der Eingabedaten mittels des Large-Language-Modells auf Basis der Kontextinformation,
• Ausgeben (S6) des generierten Funktionsaufrufs,
und
• Ansteuern (S7) des Bearbeitungstools zum Bearbeiten des 3D-Modells gemäß dem Funktionsaufruf.

8. Computerprogrammprodukt, das direkt in einen programmierbaren Computer ladbar ist, umfassend Programmcodeteile, die dazu geeignet sind, die Schritte des Verfahrens nach Anspruch 7 durchzuführen.
